(19) Europäisches Patentamt
European Patent Office
Office européen des brevets

(11) **EP 2 760 050 B1**

(12) **EUROPEAN PATENT SPECIFICATION**

(45) Date of publication and mention
of the grant of the patent:
**25.01.2017 Bulletin 2017/04**

(51) Int Cl.:
*H01L 29/66* (2006.01)          *B82Y 10/00* (2011.01)
*H01L 29/76* (2006.01)          *H01L 29/12* (2006.01)

(21) Application number: **13153131.1**

(22) Date of filing: **29.01.2013**

(54) **Method of initialising a hole spin in a quantum-dot device**

Methode zum Initialisieren eines Loch-Spins in einer Quantenpunktvorrichtung

Méthode d'initialiser un spin de trou dans un dispositif de point quantique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**30.07.2014 Bulletin 2014/31**

(73) Proprietor: **Hitachi, Ltd.**
**Tokyo (JP)**

(72) Inventors:
• **Mar, Jonathan**
  **Cambridge, Cambridgeshire CB3 0HE (GB)**
• **Williams, David**
  **Cambridge, Cambridgeshire CB3 0HE (GB)**
• **Baumberg, Jeremy**
  **Cambridge, Cambridgeshire CB3 0HE (GB)**
• **Xu, Xiulai**
  **Beijing 100190 (CN)**

(74) Representative: **Piotrowicz, Pawel Jan Andrzej et al**
**Venner Shipley LLP**
**Byron House**
**Cambridge Business Park**
**Cowley Road**
**Cambridge CB4 0WZ (GB)**

(56) References cited:
**GB-A- 2 439 595      US-B1- 6 728 281**

• MAR J ET AL: "Electrically tunable hole tunnelling from a single self-assembled quantum dot embedded in an n-i-Schottky photovoltaic cell", APPLIED PHYSICS LETTERS, AIP, AMERICAN INSTITUTE OF PHYSICS, MELVILLE, NY, US, vol. 99, no. 3, 18 July 2011 (2011-07-18), pages 31102-31102, XP012141444, ISSN: 0003-6951, DOI: 10.1063/1.3614418
• D. HEISS ET AL: "Observation of extremely slow hole spin relaxation in self-assembled quantum dots", PHYSICAL REVIEW B, vol. 76, no. 24, 1 December 2007 (2007-12-01), XP055066797, ISSN: 1098-0121, DOI: 10.1103/PhysRevB.76.241306
• EBLE B ET AL: "Hole spin initialization in quantum dots by a periodic train of short pulses", JOURNAL OF PHYSICS: CONFERENCE SERIES, INSTITUTE OF PHYSICS PUBLISHING, BRISTOL, GB, vol. 210, no. 1, 1 February 2010 (2010-02-01), page 12031, XP020177907, ISSN: 1742-6596

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a quantum-dot device, in particular a quantum-dot device in which fast, high-fidelity hole-spin initialization can be achieved without the need for an applied magnetic field. The present invention also relates to a method of initializing hole spin in a quantum-dot device, in particularly a quantum-dot device for use in quantum information processing.

Spin of an electron or hole which is confined in a semiconductor quantum dot offers to be a promising candidate for a quantum bit (qubit) in a quantum computer. Electron or hole spin tends to have long relaxation and decoherence times which are parameters which limit how long stored information is available for use in quantum computations.

To be used effectively in quantum computers, qubits need to meet a number of requirements.

Firstly, it should be possible to initialize individual spins in a known state with high fidelity.

Secondly, to implement quantum error correction schemes for fault-tolerant quantum computing, it should be possible to re-initialise ancillary qubits repeatedly during a computation at rates $10^4$ - $10^5$ times faster than the decoherence rate. The decoherence time for a quantum dot electron and hole spin has been found to be 1 μs and 100 ns respectively. Therefore, quantum dot spin initialization should be performed at terahertz (THz) frequencies.

Thirdly, qubits should be realized in a scalable physical system.

Current systems tend to satisfy only one or two of these requirements.

Various methods of initialising quantum dot spins with high fidelity are known and are described in J. R. Petta et al.: "Coherent manipulation of coupled electron spins in semiconductor quantum dots", Science, volume 309, page 2180 (2005), B. D. Gerardot et al.: "Optical pumping of a single hole spin in a quantum dot", Nature, volume 451, page 441 (2008), M. Atatüre et al.: "Quantum-dot spin-state preparation with near-unity fidelity", Science, volume 312, page 551 (2006), X. Xu et al.: "Fast spin state initialization in a singly charged InAs-GaAs quantum dot by optical cooling", Physical Review Letters, volume 99, page 097401 (2007), D. Press et al: "Complete quantum control of a single quantum dot spin using ultrafast optical pulses", Nature, volume 456, page 218 (2008) and T. M. Godden et al: "Fast high fidelity hole spin initialization in a single InGaAs quantum dot", Applied Physics Letters, volume 97, page 061113 (2010). However, initialization rates were at least three orders of magnitude too slow (i.e. less than 1 GHz) for implementing quantum error correction schemes and/or necessitated the use of applied magnetic fields. The use of applied magnetic fields significantly reduces scalability.

J. D. Mar et al.: "Electrically tunable hole tunnelling from a single self-assembled quantum dot embedded in an n-i-Schottky photovoltaic cell", Applied Physics Letters, volume 99, page 031102 (2011) describes excitation-intensity-dependent measurements of a neutral exciton photocurrent peak amplitude from a single InAs/GaAs self-assembled quantum dot embedded in the intrinsic region of an *n-i*-Schottky photodiode.

D. Heiss et al.: "Observation of extremely slow hole spin relaxation in self-assembled quantum dots", Physical Review B, volume 76, page 241306 (2007) describes measurement of extremely slow hole spin relaxation dynamics in small ensembles of self-assembled InGaAs quantum dots. B. Eble et al.: "Hole spin initialization in Quantum Dots by a periodic train of short pulses", Journal of Physics: Conference Series, volume 210, page 012031 (2010) describes pump-probe experiments leading to the all-optical initialization of the hole spin of a p-doped InAs/GaAs quantum dots ensemble. These processes too necessitate the use of applied magnetic fields.

According to a first aspect of the present invention there is provided a method of initialising hole spin in device comprising a semiconductor region which comprises a first semiconductor material and quantum dot which comprises a second semiconductor material embedded in the semiconductor region. The quantum dot exhibits a bound hole state lying a first energy ($\Delta E_{Veff}$) below a valence band edge of the semiconductor region and a bound electron state lying a second energy ($\Delta E_{Ceff}$) below a conduction band edge of the semiconductor region. A ratio ($\Delta E_{Ceff}/\Delta E_{Veff}$) of the second and first energies is no more than 2.0. The difference in effective masses of the electron ($m_e^*$) and the hole ($m_h^*$) results in an electron tunnelling rate ($\Gamma_e$) that is at least three orders of magnitude faster than a hole tunnelling rate ($\Gamma_h$). The electron tunnelling rate ($\Gamma_e$) is at least two orders of magnitude faster than the characteristic rate corresponding to the precession caused by the fine structure splitting in the quantum dot ($\delta_{FS}/h$). The method comprises applying a first, reverse bias across the semiconductor region, generating an exciton in a quantum dot and reversing the bias voltage by applying a second, different bias across the semiconductor region (3), at a time after exciton generation long compared to the characteristic time corresponding to the electron tunnelling rate ($\Gamma$e) and short compared to the characteristic time corresponding to the hole tunnelling rate ($\Gamma$h).

Fast, high-fidelity hole-spin initialization can be achieved without the need for an applied magnetic field.

The bound hole state may be a ground hole state. The bound electron state may be a ground electron state.

The ratio may be at least 1.0. The ratio may be no more than 1.5 or no more than 1.3.

The quantum dot may comprise a self-assembled quantum dot.

The quantum dot may be formed by Stranski-Krastanov growth.

The semiconductor region may comprise intrinsic semiconductor material.

The semiconductor region may comprise a first region of semiconductor material of a first conductivity type and a second region of semiconductor material of a second opposite conductivity type and the semiconductor region is depleted.

The quantum dot may have a smallest dimension (H) no more than 5 nm.

The first semiconductor material may be a III-V semiconductor material. The second semiconductor material may be a III-V semiconductor material. For example, the first semiconductor material may be gallium arsenide. The second semiconductor material may comprise indium arsenide.

The first semiconductor material may be a II-VI semiconductor material. The second semiconductor material may be a II-VI semiconductor material.

The semiconductor region may be sandwiched between first and second electrodes so as to allow application of an electric field across the semiconductor region (and, since it is embedded in the semiconductor region, the quantum dot).

The device may take form of a photodiode.

The second bias may generate a higher electric field across the semiconductor region than the first bias. The method may further comprise removing the first bias and applying no bias (or a sufficiently low bias) across the semiconductor region for a given time before applying the second bias.

According to a second aspect of the present invention there is provided a method of quantum information processing including initialising hole spin and performing a transformation from an initial state into a final state.

The method may further comprise reading out the final state.

Certain embodiments of the present invention will now be described, by way of example, with reference to the accompanying drawings in which:

Figure 1 is a schematic diagram of a device in which fast, high-fidelity hole spin initialization can be achieved without the need for an applied magnetic field;
Figure 2 is a schematic band diagram a quantum dot in the device shown in Figure 1;
Figure 3 illustrates a system for initializing a hole spin in the device shown in Figure 1 including a voltage source for applying a bias voltage, $V_b$, and a laser for applying circularly-polarized light to the quantum dot;
Figures 4a to 4f illustrates a process of initializing a hole spin;
Figure 5 is a schematic diagram of energy levels of the quantum dot shown in Figure 2 at different stages during an initialisation process;
Figure 6 is a schematic diagram of a device comprising InAs/GaAs self-assembled quantum dots in which fast, high-fidelity hole spin initialization can be achieved without the need for an applied magnetic field;
Figure 7 shows computed valance band edge and conduction band edge for the device shown in Figure 6;
Figure 8 shows plots of measured electron tunnelling rate, hole tunnelling rate and X° spin precession frequency due to X° fine-structure splitting obtain by photoconductive spectroscopy of a single InAs/GaAs self-assembled quantum dot;
Figures 9a and 9b shows plots of measured fidelity of spin up and spin down hole-spin; and
Figure 10 shows plots of measured lower bounds of fidelity and hole tunnelling time as a function of bias voltage, $V_b$, and electric field, $F$.

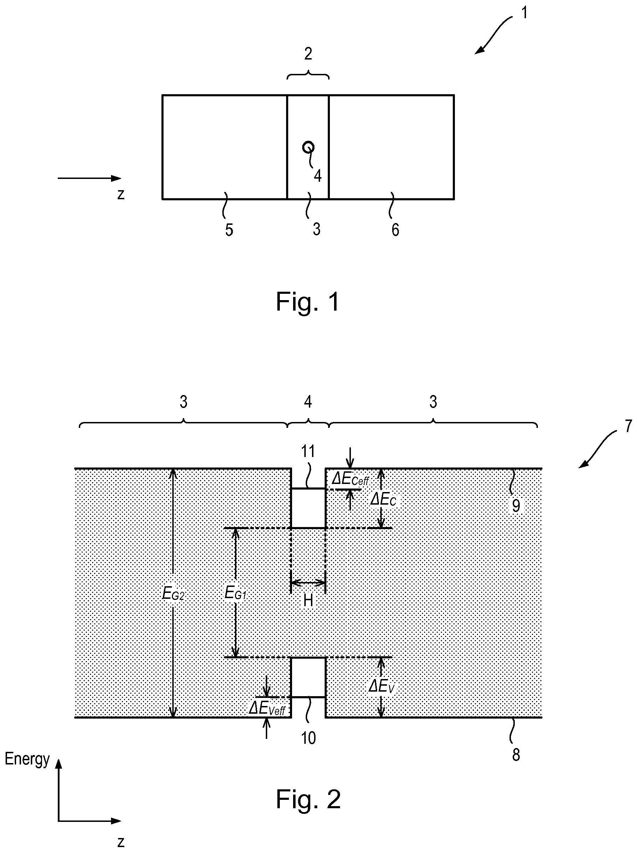

Referring to Figure 1, a device 1 in which fast, high-fidelity hole-spin initialization can be achieved without the need for an applied magnetic field is shown. The device 1 takes the form of a photodiode which comprises a heterostructure 2 comprising an intrinsic or depleted semiconductor region 3, a semiconductor quantum dot 4 embedded in the semiconductor region 3 and first and second contact regions 5, 6 sandwiching the semiconductor region 3. As will be explained in more detail later, the photodiode 1 may take the form of a p-i-n photodiode or p-n junction.

Referring also to Figure 2, a band structure 7 for the heterostructure 2 is shown. The band structure 7 includes valance and conduction band edges 8, 9 separated by a band gap. The semiconductor quantum dot 4 comprises a semiconductor material having a first band gap, $E_{G1}$, which is smaller than a second band gap, $E_{G2}$, of the material(s) forming the semiconductor region 3. The semiconductor region 3 and the quantum dot 4 have a conduction band offset $\Delta E_C$ and a valence band offset $\Delta E_V$.

The quantum dot 4 includes a ground electron state 10 and a ground hole state 11. The quantum dot 4 may include at least one excited state (not shown).

As will be explained later, the hole state 10 lies a first energy, $\Delta E_{Veff}$, below the valence band edge 8 of the semiconductor region 3 and the electron state 11 lies a second energy, $\Delta E_{Ceff}$, below the conduction band edge 9 of the semiconductor region. The quantum dot 4 and the semiconductor region 3 are arranged, by choosing materials which provide suitable values of effective mass and $\Delta E_C/\Delta E_V$ and by selecting a suitable width, H, of quantum well 4, such that the ratio of effective band offsets for the electron and hole states 11, 10, $\Delta E_{Ceff}/\Delta E_{Veff}$, is small, that is, no more than 2.0. For example, the ratio may be no more than 1.5 or even no more than 1.3.

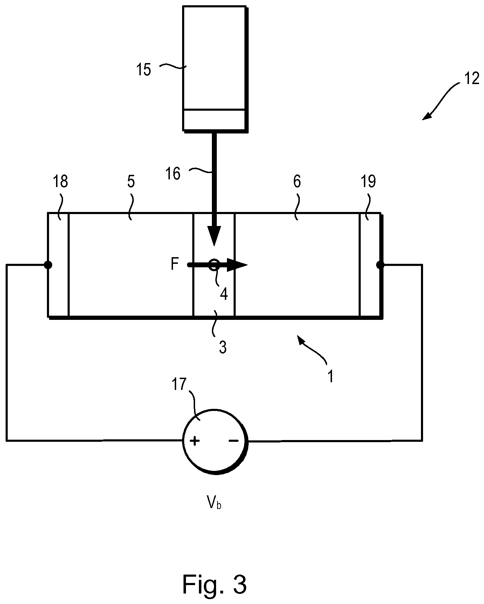

Referring to Figure 3, apparatus 12 for initializing hole spin in the quantum dot 4 in the photodiode 1 is shown.

The apparatus 12 includes a laser 15 for illuminating the quantum dot 4 with circularly-polarised light 16 and a voltage source 17 for applying a bias voltage, $V_b$, between first and second contacts 18, 19 made to the first and second contact regions 5, 6 respectively. The laser 15 can operate in continuous-wave or pulsed mode. The laser 15 is tuned to the transition between the electron and hole states 11, 10. In this example, the light 16 lies in near-infrared or visible parts of the electromagnetic spectrum.

By controlling the bias voltage, $V_b$, across the photodiode 1, the electric field, F, at the location of the quantum dot 4 can be controlled. Therefore, an electric-field-controlled electron tunnelling rate $\Gamma_e$ and hole tunnelling rate $\Gamma_h$ out of the quantum dot can be controlled by controlling the bias voltage, $V_b$.

Referring to Figures 3, 4a to 4f and 5, a process of fast, high-fidelity initialization of a quantum dot hole-spin will now be described.

In the following description, $\uparrow$ and $\downarrow$ represent a spin-up and a spin-down electron respectively and $\Uparrow$ and $\Downarrow$ represent a spin-up and a spin-down hole respectively. A braket $| \rangle$ indicates a quantum dot state.

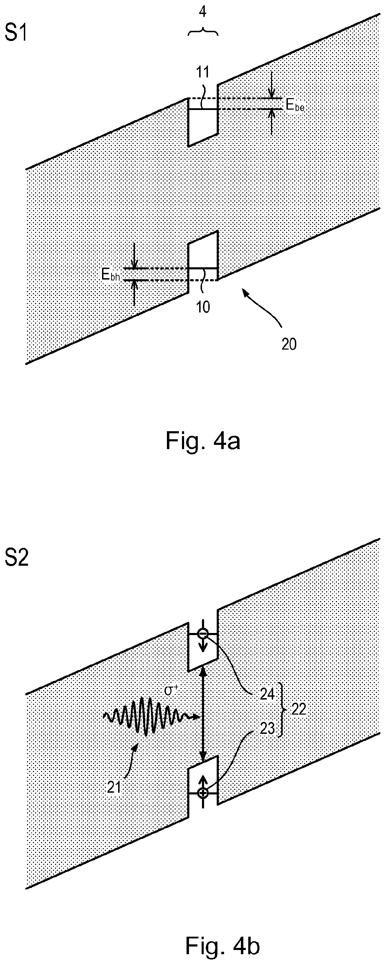

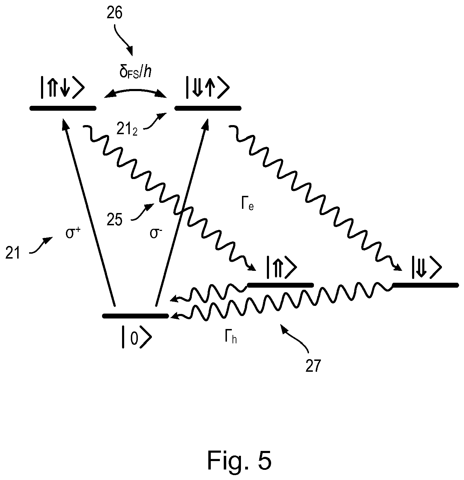

Referring in particular to Figure 4a and 5, the quantum dot 4 is initially empty of carriers in a ground state 20 and the photodiode 1 is reverse biased (step S1).

As shown in Figure 4a, an electric field, F, is applied to the heterostructure 2. Under an applied electric field, $E_{bh}$ is the tunnel barrier height for a hole tunnelling out of the quantum dot 4 from the ground state 10 and $E_{be}$ is the tunnel barrier height for an electron tunnelling out of the quantum dot 4 from the ground state 11.

Referring in particular to Figure 4b and 5, right/left circularly polarized ($\sigma^{+/-}$) laser field 21 resonantly excites a neutral exciton (X°) 22 in the lowest-energy quantum dot exciton state with spin angular momentum in the z-direction (i.e. semiconductor growth direction) $M_z = \pm 1$, consisting of a spin-up (-down) heavy hole 23 with spin $J_z = \pm 3/2$ and a spin-down (-up) electron 24 with spin $S_z = \mp 1/2$ (step S2). A short, intense laser pulse 21 which has a duration shorter than the coherence time of the quantum dot exciton and a pulse area of $(2n+1)\pi$ where n is an integer can be used to perform a complete population inversion from the quantum dot ground-state 20 (i.e. an empty quantum dot) to the X° state 22.

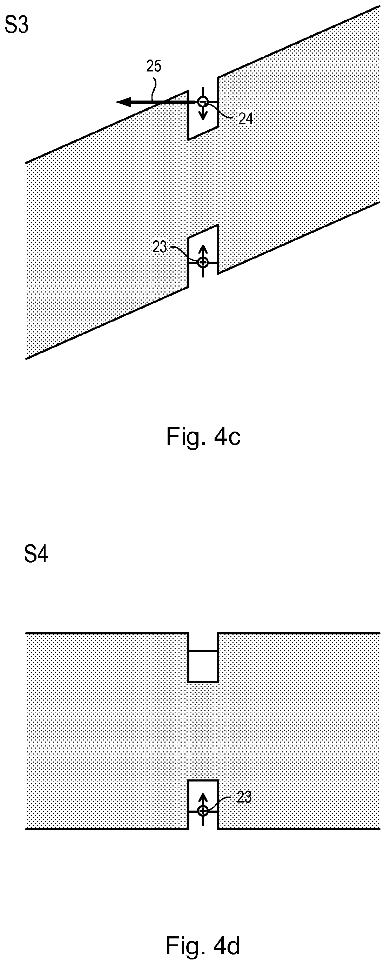

Referring in particular to Figure 4c and 5, since the effective mass of the electron 24 is much smaller than that of the heavy hole 23, excitation of X° is followed by rapid ionization of X° via electron tunnelling 25 at a rate $\Gamma_e$ that is determined by the electric field, F, thereby leaving a single hole 23 in the quantum dot 4 initialized with a known spin (step S3). The spin is configured by the laser polarization. For example, $\sigma^+$-polarized excitation followed by exciton ionization results in the initialization of a spin-up hole 23. The electron tunnelling rate is equivalent to the hole-spin initialization rate. The electron tunnelling rate $\Gamma_e$ out of the quantum dot 4 can be modelled via a one-dimensional (1D) Wentzel-Kramers-Brillouin (WKB) approximation using equation (1) below:

$$\Gamma_e = \frac{\hbar\pi}{2m_e^* H^2} \exp\left[ \frac{-4}{3\hbar e F} \sqrt{2m_e^* E_{be}^3} \right] \tag{1}$$

where $m_e^*$ is the electron effective mass in the barrier material, H is the spatial extent of the quantum dot 4 in the direction of the electric field if the quantum dot potential in this direction is approximated as a one-dimensional potential well, e is the elementary charge, $E_{be}$ is the tunnel barrier height for the electron tunnelling out of the quantum dot 4 and $\hbar$ is the reduced Planck's constant.

$\Gamma_e$ (and, thus, the initialization rate) can be performed at terahertz frequencies using realistic electric field strengths F along with a barrier height, $E_{be}$, between the lowest-energy quantum dot electron level 11 and the barrier's conduction-band edge 9 of a few tens of millielectron volts. For example, for a typical self-assembled quantum dot for which H = 5 nm, $E_{be}$ = 50 meV to a GaAs barrier conduction-band edge, F = 45 kV/cm and an electron effective mass in GaAs $m_e^*$ = 0.067 $m_e$ where $m_e$ = 9.11 $\times$ 10$^{-31}$ kg is the electron mass in vacuum, the electron tunnelling rate, $\Gamma_e$, out of the quantum dot 4 is 1.3 THz which is equivalent to an electron tunnelling time of 0.75 ps.

Prior to ionization via electron tunnelling 25, however, the X° spin precesses about an axis in the plane of the quantum dot (i.e. perpendicular to the z-direction growth axis) and between states $M_z = \pm 1$ due to exciton fine-structure splitting $\delta_{FS}$ 26, which is caused by an anisotropic electron-hole exchange energy in quantum dots (particularly self-assembled quantum dots) resulting in linearly polarized eigenstates. Such X° spin precession thus can lead to a loss in hole-spin initialization fidelity if the X° spin precession frequency $\delta_{FS}/h$ (where h is Planck's constant) is comparable to $\Gamma_e$. Therefore, to achieve high-fidelity initialization, $\Gamma_e$ is arranged to be much greater than $\delta_{FS}/h$. The value of $\delta_{FS}/h$ is typically about 1 - 10 GHz (i.e. $\delta_{FS}$ = 1 - 10 $\mu$eV) in self-assembled quantum dots.

In accordance with the present invention, the photodiode 1 is arranged such that the electron 24 tunnels out of the quantum dot 4 more than two orders of magnitude faster than $\delta_{FS}/h$ thus leading to near-unity fidelity initialization along with THz initialization of the hole spin. Therefore, there is no need for a strong applied magnetic field to be applied in the z-direction to inhibit X° spin precession about the in-plane axis, which is due to X° fine structure splitting, and maintain the X° spin in the z-direction until the electron 23 tunnels out. The hole-spin initialization fidelity achieved using this scheme can be modelled using equation (2) below, namely:

$$\text{Fidelity} = 1 - \frac{1}{2}\left[\frac{\left(\delta_{FS}/h\right)^2}{\left(\delta_{FS}/h\right)^2 + \omega_z^2 + \left(\Gamma_e - \Gamma_h\right)^2}\right] \tag{2}$$

where $\omega_z$ is the Zeeman frequency for an applied magnetic field in the z-direction (i.e. the direction of the initial X° spin). In this case, $\omega_z$ is zero because there is no applied magnetic field. Based on equation (2) above, near-unity fidelity hole-spin initialization can be achieved using the process described herein. For example, for $\Gamma_e$ = 1.3 THz, $\delta_{FS}/h$ = 50 GHz (i .e. $\delta_{FS}$ = 207 $\mu$eV), and $\Gamma_h$ much smaller than $\Gamma_e$, the initialization fidelity is 99.93% (i.e. a loss in fidelity of <10$^{-3}$).

Due to the much larger effective mass of the heavy hole 23 compared to the electron 24, the small conduction-band to valence-band offset ratio of the quantum dot allows the hole 23 to remain in the quantum dot 4 for more than three orders of magnitude longer than the electron 24. The hole tunnelling rate out of the quantum dot can be modelled in a similar way to that of the electron via a one-dimensional WKB approximation, namely:

$$\Gamma_h = \frac{\hbar\pi}{2m_h^* H^2}\exp\left[\frac{-4}{3\hbar eF}\sqrt{2m_h^* E_{bh}^3}\right] \tag{3}$$

where $m_h^*$ is the heavy-hole effective mass and $E_{bh}$ is the tunnel barrier height for the heavy hole 24 tunnelling out of the quantum dot 4. Therefore, using a conduction-band to valence-band offset ratio of 1.25 whereby $E_{bh}$ = 40 meV for the tunnelling hole 23, an electric field of F = 45 kV/cm and $m_h^*$ = 0.59 $m_e$ in GaAs, the hole tunnelling rate $\Gamma_h$ out of the quantum dot is 1.1 GHz (corresponding to a hole tunnelling time of 0.91 ns). In other words, the hole 23 remains in the quantum dot 4 for more than three orders of magnitude longer than the electron 23.

This allows hole-spin to be stored in the quantum dot 4 under low electric-field conditions by fast-switching to a low reverse-bias voltage at a time that is both much longer than the electron tunnelling time and much shorter than the hole tunnelling time, leading to near-unity efficiency storage of the hole spin as shown in Figure 4d. For example, if fast-switching to an appropriate low reverse-bias voltage is performed 5 ps following the optical excitation of X° as hereinbefore described, where the electron tunnelling time is 0.75 ps and the hole tunnelling time is 0.91 ns, then a spin-storage efficiency of 99.3% is achieved. Storage of the hole spin is required for subsequent quantum computing operations to be performed on it during its coherence time.

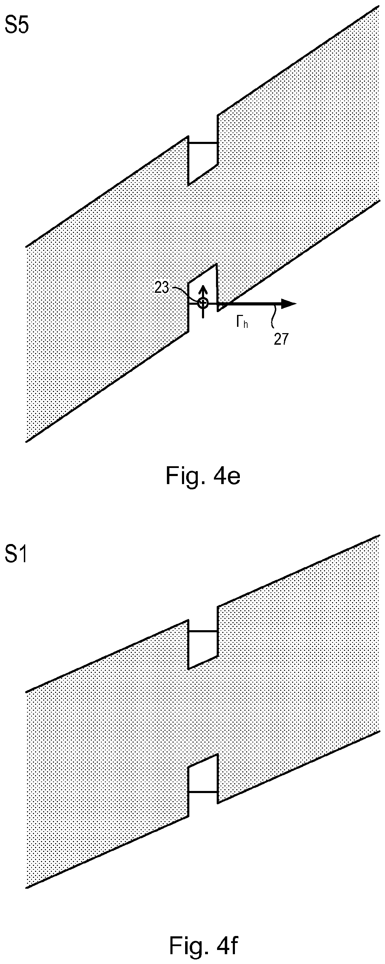

Referring to Figures 4e and 5, re-initialization of the hole-spin can be performed by first fast-switching to a high electric field to cause the hole 23 to tunnel out of the quantum dot 4 at terahertz frequencies. For example, switching to an electric field $F$ = 170 kV/cm, the hole 23 tunnels out of the quantum dot at a rate of $\Gamma_h$ = 1.04 THz (corresponding to a hole tunnelling time of 0.96 ps). Then, F (via $V_b$) is returned to its initial value to repeat the hole-spin initialization.

The quantum dot 4 is thus left empty of carriers in a ground state 20 as shown in Figure 4f.

The hole-spin initialization process can also be used to initialize hole spin in any direction (i.e. any point on the Bloch sphere) by using a laser field with the appropriate polarization.

The process can be used to initialise hole-spin in an excited state (e.g. in p shell or d shell).

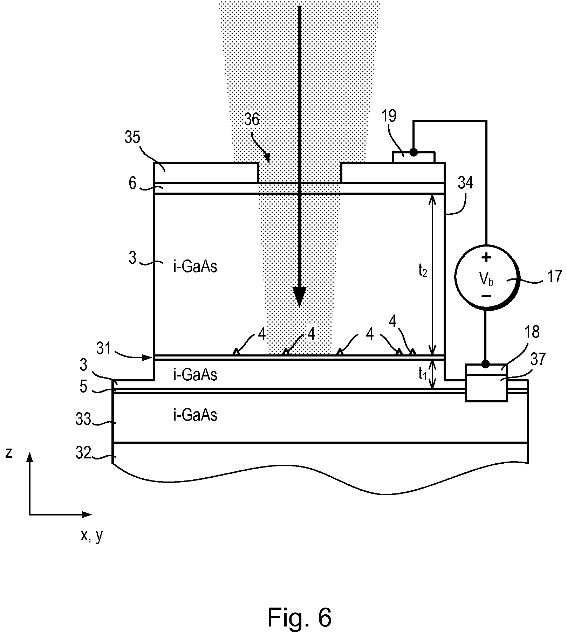

Referring to Figure 6, the photodiode 1 is shown in greater detail.

The photodiode 1 comprises a single layer 31 of indium arsenide (InAs) self-assembled quantum dots 4 embedded in a layer 3 of intrinsic gallium arsenide (GaAs) having a thickness, ($t_1$ + $t_2$), of 250 nm of an n-i-Schottky photodiode structure grown by molecular beam epitaxy (MBE) on a gallium arsenide substrate 32 and buffer layer 33. The self-assembled quantum dots 4 are formed via Stranski-Krastanov (SK) growth.

An n-type semiconductor contact region 5 is provided by a two-dimensional electron gas (2DEG) formed by a silicon $\delta$-doped gallium arsenide (GaAs) layer having a donor doping concentration $N_d = 5 \times 10^{12}$ cm$^{-2}$ which is located 50 nm (i.e. $t_1$ = 50 nm) below the quantum dot layer 31. The $\delta$-doped layer 5 allows electric-field-tunable carrier tunnelling out of the quantum dot 4 and bias-controlled single-electron charging when the quantum dot s shell (i.e. the lowest-energy) electron level is shifted above or below the Fermi level, $E_F$, of the 2DEG, respectively, via a suitable tuning of the bias voltage $V_b$ between the two-dimensional electron gas and a Schottky contact 6.

To allow the possibility for optical interaction with a single quantum dot 4, an InAs thickness-gradient along the wafer was used to yield a small area with a low surface-density of quantum dots 4 (about 10$^9$ cm$^{-2}$) near the critical thickness for quantum dot formation. Having obtained a sample containing a low surface-density of quantum dots 4, the photodiode's active area was defined by wet-etching, to a level slightly above the $\delta$-doped layer 5, a square mesa 34 onto which a semi-transparent Schottky contact 6 is formed using a layer of titanium (Ti) having a thickness of 10 nm.

To select a single quantum dot 4 for optical interaction, a near-field shadow mask 35 having a sub-micrometer-sized aperture 36 is formed by evaporating a layer of aluminium onto the Schottky contact, patterning the layer using electron-beam lithography and wet-etching to form the aperture 36. A gold-germanium-nickel (AuGe-Ni) ohmic contact 37 is formed to the δ-doped layer 5 away from the mesa 34 and chromium/gold (Cr/Au) bond pads 18, 19 are formed on the ohmic contact 18 and shadow mask 35 for connection to an external electrical circuit.

At the quantum dot layer 31, $F = (V_i\text{-}V_b)/d$ where $V_i$ is the intrinsic built-in potential of the Schottky barrier and d the distance between the δ-doped layer 5 and the Schottky contact 6.

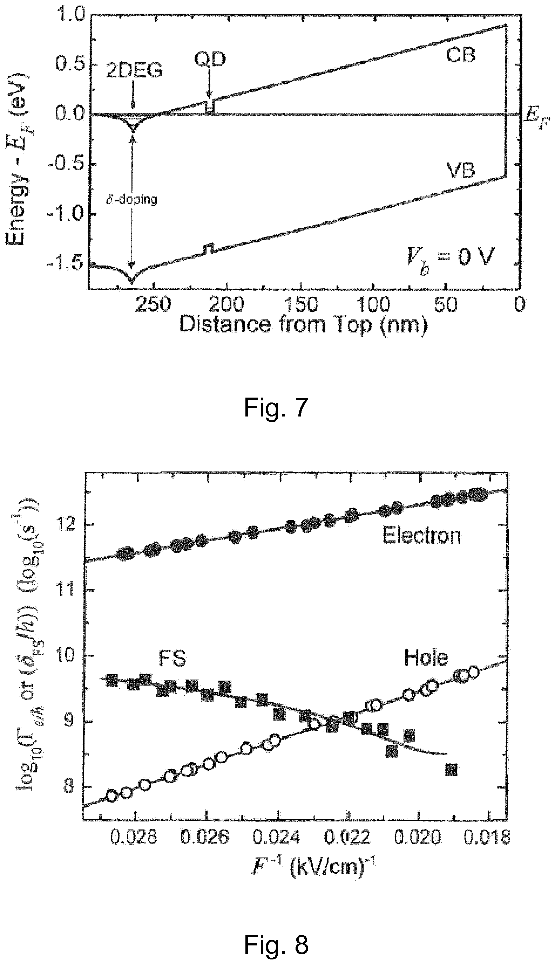

Referring to Figure 7, plots of valance band and conduction band edges 8, 9, the quantum dot s shell hole and electron levels 10, 11 and confined electron states 38 of the 2DEG are shown. The plots are obtained by using a 1D self-consistent Poisson-Schrödinger solver in the growth direction (direction of the applied electric field, z-direction) where the 2DEG is confined in a 'V'-shaped potential well as a result of the δ-doping. For the calculation, it was assumed that the s-shell X° exciton transition energy for the InAs/GaAs self-assembled quantum dot 4 is 1.34 eV, the quantum dot height H (in the growth direction) is 5 nm and the temperature of the device is 4.2 K. As shown in the calculation, for $V_b$ = oV, the quantum dot s-shell electron level 11 is energetically positioned well above the Fermi energy $E_F$.

In order to obtain a quantum dot 4 with a low conduction band to valence band offset ratio, a quantum dot 4 with a reduced height (i.e. reduced dimension in the applied electric field direction and growth direction) is used. Such a quantum dot 4 can be characterized as having a relatively high transition energy. The rationale for using a short quantum dot can be understood by considering the quantum dot as a 1D potential well (in the direction of the applied electric field and carrier tunnelling) with quantized energy levels given by:

$$E_n = \frac{(n\hbar\pi)^2}{2m^*_{e/h}H^2} \tag{4}$$

where $m_e/h^*$ is the electron/heavy-hole effective mass in GaAs, $H$ is the quantum dot height (i.e. potential well width) and n is the energy-level index. Thus, since $m_e^*$ = 0.067 $m_e$ is nearly an order of magnitude smaller than $m_h^*$ = 0.59 $m_e$ in GaAs where $m_e$ is the electron mass in vacuum, reducing H results in a decrease in the ratio of conduction band to valence band offsets. This in turn leads to an increase in the ratio of electron to hole tunnelling rates which vary exponentially with their respective band offsets. Since reducing H also results in an increase in the quantum dot transition energies, quantum dots with low conduction-to-valence band offset ratios in the case of high-energy quantum dots can be found. Small, high-energy quantum dots intrinsically possess small values of $\delta_{FS}$. Such an effect is due to an increased in-plane expansion of the exciton, as a result of the decreased confinement energy (i.e. band offset), leading to a reduction in the electron-hole exchange energy and, hence, $\delta_{FS}$. Therefore, a small high-energy quantum dot is used to obtain a quantum dot 4 having a low conduction band to valence band offset ratio.

X° absorption spectrum can be obtained using photocurrent (PC) spectroscopy, where resonant optical excitation using a narrow-bandwidth continuous-wave laser is followed by electron and hole tunnelling out of the quantum dot 3 and towards the 2DEG and Schottky contact, respectively, under high electric-fields (i.e. reverse-bias voltages), resulting in a measurable PC signal across the photodiode 1. A spectrum of X° can thus be obtained by sweeping its transition energy through a fixed laser energy E°$_{laser}$ via the quantum-confined Stark effect (QCSE), which is in turn controlled by $V_b$. By repeating this measurement for a series of known laser energies, a range of corresponding values for E°$_{laser}$ and peak $V_b$ is generated from which a precise conversion between X° transition energy and $V_b$ is derived by fitting a quadratic function to the experimental data. Measurements were performed with the temperature of the device being 4.2 K.

Small high-energy, self-assembled quantum dots 4 are found near the critical InAs-thickness for quantum dot formation on the wafer which is also where a low surface-density of quantum dots is obtained to allow for optical measurements on single quantum dots 4. A suitable single quantum dot is selected with an X° transition energy of about 1.364 eV. As a function of $V_b$ (i.e. vertical electric field $F$), $\Gamma_e$ is measured from the laser-intensity-dependent X° homogeneous line width using PC spectroscopy, $\Gamma_h$ is measured from the saturation of the X° PC peak amplitude towards high laser intensities and $\delta_{FS}$ from PC spectroscopy of each of the X° fine-structure split eigenstates using a linearly polarized laser aligned either to the [110] or [1-10] crystallographic axis.

As shown in Figure 8, the measurements reveal that $\Gamma_e$ is about three orders of magnitude faster than $\Gamma_h$ throughout the measurable PC range for X°. Also, fitting the theoretical models based on a 1D WKB approximation for $\Gamma_e$ using equation (1) above and $\Gamma_h$ using equation (3) above to the experimental data, a conduction band to valence band offset ratio of 1.29 (= 52.2 meV/40.5 meV) is extracted for this quantum dot 4. T. M. Godden et al. *ibid.* described using In(Ga)As/GaAs self-assembled quantum dots having much lower transition energies, where the ratio of $\Gamma_e$ to $\Gamma_h$ is nearly a factor of $10^2$ smaller and the conduction band to valence band offset ratio is nearly a factor of two larger.

The theoretical fits shown in Figure 8 for $\Gamma_e$ and $\Gamma_h$ also yield small values for the quantum dot height, H, of 4.4 nm and 4.5 nm respectively. The results shown in Figure 8 also shows that $\Gamma_e$ is between two and four orders of magnitude larger than $\delta_{FS}$/h over the measurable PC range. The fit curve for $\delta_{FS}$/h in Figure 5 is obtained from the difference between the quadratic fit curves of the $V_b$ versus transition energy data for the two linearly-polarized X° eigenstates. Without wishing to be bound to a particular theory, the observed decrease in $\delta_{FS}$ with increasing F which corresponds to a reduction of $\delta_{FS}$ from approximately 18 μeV to approximately 1 μeV is most likely the result of an in-plane symmetrizing and/or vertical spatial separation of electron and hole wave functions in the quantum dot 4.

It was not possible to perform these measurements on larger, lower-energy quantum dots for comparison on the same wafer since such quantum dots can only be found towards areas on the wafer of increasing InAs-thickness where the quantum dot surface-density becomes too large to allow for optical measurements on single quantum dots.

The initialization fidelity for a quantum dot hole spin is measured using the device 1. Having initialized a hole spin as hereinbefore described, measurement of initialization fidelity is achieved by using a second circularly polarized laser field resonant with the positive trion state (X⁺) in the quantum dot which is comprised of two holes in a spin-singlet and an electron with either spin so as to compare the probabilities of exciting X⁺ for cross- and co-polarized laser excitation relative to the first laser. Excitation of X⁺ from a given hole spin-state is conditional on the polarization of the second laser due to optical selection rules. For example, for initialization of a spin-up hole using a σ⁺-polarized laser tuned to the X° transition, the initialization fidelity is measured by comparing the probabilities of exciting X⁺ for σ⁻- and σ⁺-polarized laser tuned to the X⁺ transition, where the former (latter) represents occupation of the spin up (-down) hole state. In order to compare the probabilities of exciting X⁺ for cross- and co-polarized laser excitation, the X⁺ absorption spectrum is measured using two-colour PC spectroscopy, where a second narrow bandwidth continuous-wave laser (either cross-or co-polarized to the first laser) is tuned to the X⁺ transition energy and the X° and X⁺ transition energies are swept through their respective laser energies ($E°laser$ and $E^+_{laser}$) roughly simultaneously. Excitation of X⁺ is conditional on the ionization of X° via fast electron tunnelling. A spectrum of X⁺ can be extracted from the resulting PC signal, which is created due to the tunnelling-out of all carriers, by subtracting the PC component due to X° and then dividing by the X° probability distribution to account for possible detuning between the transition energy and laser energy separations. In a similar approach to the case of X°, a precise conversion between X⁺ transition energy and $V_b$ is derived.

As explained earlier, the fidelity is measured by comparing the X⁺ PC peak amplitudes between cross- and co-circularly polarized excitation for the laser resonant to X⁺ relative to the laser resonant to X°. For the initialization of a spin-up hole, the initialization fidelity is defined as $PC_{+/-}/( PC_{+/-} + PC_{+/+})$, where $PC_{+/-}$ ($PC_{+/+}$) is the X⁺ PC peak amplitude for a σ⁺-polarized X° laser and a σ⁻- (σ⁺-)polarized X⁺ laser. An analogous definition for the initialization fidelity of a spin-down hole can be derived.

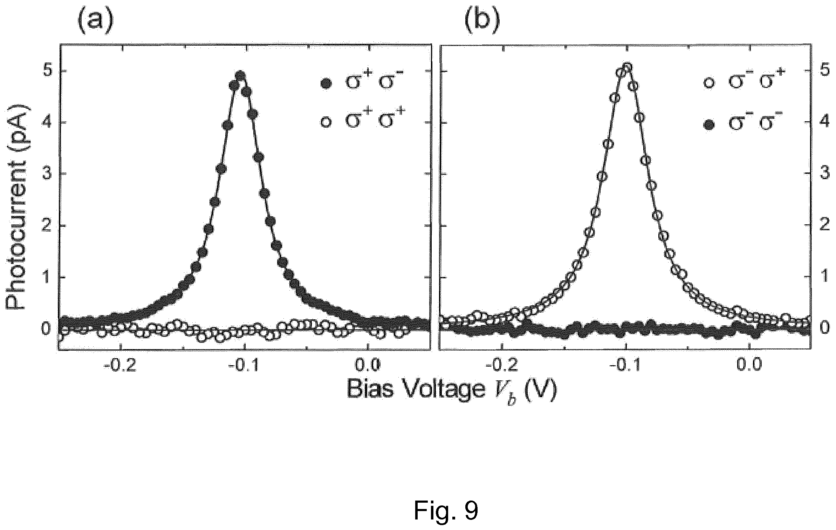

Referring to Figures 9a and 9b, results show very high contrast in the X⁺ PC peak amplitudes between cross- and co-polarized excitation in the case of both spin-up (as shown in Figure 9a) and spin-down (as shown in Figure 9b) initialization, which is expected since the two spin-states are energetically degenerate in the absence of an applied magnetic field. The results demonstrate lower bounds for the spin-up and spin-down initialization fidelities of 97.1 % and 96.9% respectively at $V_b$ = -104.4 mV ($F^{-1}$ = 0.0249 (kV/cm)$^{-1}$). It is noted that the PC peak vanishes below the noise level when the lasers are co-polarized. Therefore, the fidelity is reported in terms of a lower bound that is determined by the error in measured fidelity and in turn the experimental signal-to-noise ratio (SNR) given that a specific higher value for the achieved fidelity cannot be confirmed experimentally. Despite the possibility that there is a slight loss of laser polarization and/or of alignment (orthogonality) of the X⁺ laser's polarization axis relative to that of the X° laser for co- (cross-)polarized excitation, the resulting change in X⁺ PC signal still remains below the noise level and, thus, does not affect the lower bounds of the fidelities. It is noted that, for the peak $V_b$ measured and shown in Figures 9a and 9b, $\Gamma_e^{-1}$ = 1.4 ps and $\Gamma_h^{-1}$ = 2.8 ns (as shown in Figure 8). This means that, in addition to high fidelity initialization, an initialization rate of 0.74 THz and high-efficiency spin-storage are demonstrated, as the hole has remained in the quantum dot 4 longer than the electron by more than three orders of magnitude. For example, if fast-switching to an appropriate low reverse-bias voltage is performed 10 ps following the generation of X°, a spin-storage efficiency of 99.6% can be achieved. In comparison, using the same voltage-switching but now with a $\Gamma_h^{-1}$ only one order of magnitude longer than the above (i.e. a ratio of $\Gamma_e$ to $\Gamma_h$ that is more than a factor of 10$^2$ smaller), the spin-storage efficiency drops to 47.8%.

Similar high values for the lower bound of fidelity are also measured at a number of increased reverse-bias voltages for initialization of a spin-up hole. This is expected since, for an increasing reverse-bias, the ratio of $\Gamma_e$ to $\delta_{FS}$/h increases (as shown in Figure 5).

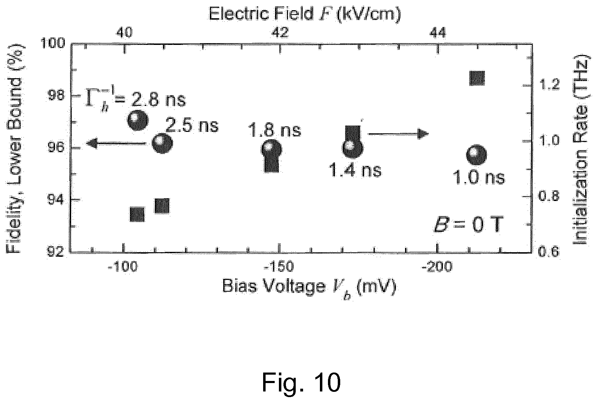

Figure 10 shows a summary of the results for fidelity along with corresponding values of initialization rate (i.e. $\Gamma_e$) and $\Gamma_h^{-1}$.

Referring to Figure 10, at $V_b$ = -212.5 mV ($F^{-1}$ = 0.0225 (kV/cm)$^{-1}$) the initialization rate is observed to increase well above 1 THz, while the lower bound of fidelity remains high (95.7%) and $\Gamma_h^{-1}$ is still more than three orders of magnitude longer than $\Gamma_e^{-1}$ to allow for a high spin-storage efficiency of 99.0% when using the same voltage switching operation as described above.

It is noted that, in all measurements, high initialization fidelities have been achieved without the application of a magnetic field (i.e. B = 0 T). The slight decrease in the measured fidelity for increasing reverse-bias is simply the result of a decrease in the X⁺ PC peak amplitude for cross-polarized excitation due to an increase in $\Gamma_h$ and hence a decrease in the X⁺ photon absorption rate, rather than the result of changes in the initialization mechanisms involved. Indeed, as shown in Figure 8, the value of the fidelity should actually increase for increasing reverse bias voltage, although this is not confirmed experimentally. It was not possible to resolve this by simply increasing the X$^+$ laser intensity used throughout these measurements since this would have led to a large increase in the noise level, greatly reducing the experimental SNR and, thus, the resulting lower bound of fidelity. It is pointed out that the fidelity was not measured for increasing reverse-biases beyond those shown in Figure 10 since the SNR and, hence, lower bound of fidelity decrease due to both an increasing background PC noise and a decreasing X$^+$ photon absorption rate, while the potential spin-storage efficiency also begins to decrease (as shown in Figure 5). On the other hand, fidelity was not measured for decreasing reverse-biases beyond those shown since a decreasing $\Gamma_h$ leads to a vanishing PC peak amplitude, while the initialization rate departs increasingly from the desired THz-frequency range.

From the measured values for $\delta_{FS}$, $\Gamma_e$ and $\Gamma_h$ shown in Figure 8, the theoretical model for initialization fidelity given in equation (2) above predicts near-unity fidelity (>99.999% or, equivalently, a loss in fidelity of <10$^{-5}$) throughout the $V_b$ range of the measured fidelities shown in Figure 10. Since the predicted values are within the measured lower bounds of fidelity, the model agrees with the experimental data. It is noted that the model predicts that a fidelity of >99.9999% or, equivalently, a loss in fidelity of <10$^{-6}$ can be achieved at $V_b$ = -212.5 mV, which corresponds to the data point towards high reverse biases in Figure 10.

The quantum dot 4 can provide a two-level qubit which can be manipulated and measured optically and/or electrically. For example, the quantum dot 4 can be manipulated using a pulse of light having suitable wavelength, polarization, duration and power. The duration of the pulse is less than the coherence time of the exciton. The state of the quantum dot 4 can be read using a photodiode. Alternatively, electrostatic gates (not shown) can be used to apply electrical pulses of suitable duration.

Plural quantum dots 4 can be arranged laterally (for example by growing alternate layers of semiconductor material and quantum dots) and/or vertically (for example patterning the surface of the semiconductor region so that quantum dots are formed preferentially in predefined positions) to form n-qubit system, where n is a positive integer greater than 1. The quantum dots 4 can interact electrostatically and/or optically.

It will be appreciated that many modifications may be made to the embodiments hereinbefore described.

The bound electron state and/or the bound hole state need not be the ground (i.e. lowest energy) state(s). Initialization can be performed also in a bound excited state, such as p shell or d shell level.

Other combinations of quantum dot material and semiconductor region material can be used. The quantum dot material can be formed via the Stranski-Krastanov mode.

For example, other combinations of binary and/or ternary III-V alloys may be used such as, for example, indium gallium arsenide (InGaAs) and gallium arsenide (GaAs), indium arsenide (InAs) and indium phosphide (InP), indium arsenide (InAs) and aluminium (AlAs), indium gallium nitride (InGaN) and gallium nitride (GaN), and gallium nitride (GaN) and aluminium nitride (AlN).

For example, combinations of binary and/or ternary II-VI alloy materials may be used such as, for example, cadmium selenide (CdSe) and zinc selenide (ZnSe), cadmium telluride (CdTe) and zinc telluride (ZnTe), zinc telluride (ZnTe) and zinc selenide (ZnSe), zinc selenide (ZnSe) and zinc sulphide (ZnS) and cadmium sulphide (CdS) and zinc selenide (ZnSe).

The quantum dot may be provided in the form of a colloidal quantum dot formed from, for example, a binary and/or ternary III-V or II-VI alloy such as, for example, cadmium selenide (CdSe), cadmium sulphide (CdS), indium arsenide (InAs), indium phosphide (InP) and cadmium selenide sulphide (CdSeS).

The quantum dot can be defined in other ways. For example, quantum dots can be defined naturally, electrically, by interface fluctuations (arising from deposition of a few monolayers of material), or by patterning (using lithography and etching).

**Claims**

**1.** A method of initialising hole spin in a device comprising a semiconductor region (3) which comprises a first semiconductor material and a quantum dot (4) which comprises a second semiconductor material embedded in the semiconductor region (3), the quantum dot (4) exhibiting a bound hole state (10) lying a first energy ($\Delta E_{Veff}$) below a valence band edge of the semiconductor region and a bound electron state (11) lying a second energy ($\Delta E_{Ceff}$) below a conduction band edge of the semiconductor region, wherein a ratio ($\Delta E_{Ceff}/\Delta E_{Veff}$) of the second and first energies is no more than 2.0,
wherein the difference in effective masses of the electron ($m_e$*) and the hole ($m_h$*) results in an electron tunnelling rate ($\Gamma_e$) that is at least three orders of magnitude faster than a hole tunnelling rate ($\Gamma_h$), and
wherein the electron tunnelling rate ($\Gamma_e$) is at least two orders of magnitude faster than the characteristic rate corresponding to the precession caused by the fine structure splitting in the quantum dot ($\delta_{FS}/h$),
the method comprising

applying a first, reverse bias across the semiconductor region (3); and

generating an exciton (22) comprising an electron and an a hole in the quantum dot (4); and

applying a second, different low reverse bias across the semiconductor region (3), at a time after exciton generation long compared to the characteristic time corresponding to the electron tunnelling rate ($\Gamma_e$) and short compared to the characteristic time corresponding to the hole tunnelling rate ($\Gamma_h$), to allow the hole spin to be stored in the quantum dot.

2. A method according to claim 1, wherein the bound hole state (10) is a ground hole state.

3. A method according to claim 1 or 2, wherein the bound electron state (11) is a ground electron state.

4. A method according to any preceding claim, wherein the ratio ($\Delta E_{Ceff}/\Delta E_{Veff}$) of the second and first energies is at least 1.

5. A method according to any preceding claim, wherein the ratio is no more than 1.5 or no more than 1.3.

6. A method according to any preceding claim, wherein the quantum dot (4) comprises a self-assembled quantum dot.

7. A method according to any one of claims 1 to 6, wherein the semiconductor region (3) comprises intrinsic semiconductor material.

8. A method according to any one of claims 1 to 6, wherein the semiconductor region (3) comprises a first region of semiconductor material of a first conductivity type and a second region of semiconductor material of a second opposite conductivity type and the semiconductor region (3) is depleted.

9. A method according to any preceding claim, wherein the quantum dot has a smallest dimension (H) no more than 5 nm.

10. A method according to any preceding claim, wherein the first semiconductor material is gallium arsenide.

11. A method according to any preceding claim, wherein the second semiconductor material comprises indium arsenide.

12. A method according to any preceding claim, wherein generating the exciton (22) in the quantum dot (4) comprises:

   illuminating the quantum dot with circularly-polarised light.

13. A method of quantum information processing comprising:

   initialising hole spin according to any preceding claim so as to prepare an initial state;
   transforming the initial state into a final state; and
   reading the final state.

**Patentansprüche**

1. Verfahren zum Initialisieren von Loch-Spin in einem Bauelement, das eine Halbleiterregion (3) mit einem ersten Halbleitermaterial und einen Quantenpunkt (4) mit einem in der Halbleiterregion (3) eingebetteten zweiten Halbleitermaterial umfasst, wobei der Quantenpunkt (4) einen gebundenen Lochzustand (10), der um eine erste Energie ($\Delta E_{Veff}$) unter einer Valenzbandkante der Halbleiterregion liegt, und einen gebundenen Elektronenzustand (11) aufweist, der um eine zweite Energie ($\Delta E_{Ceff}$) unter einer Leitungsbandkante der Halbleiterregion liegt, wobei ein Verhältnis ($\Delta E_{Ceff}/\Delta E_{Veff}$) zwischen der ersten und der zweiten Energie maximal 2,0 beträgt, wobei die Differenz der effektiven Massen des Elektrons ($m_e{}^*$) und des Lochs ($m_h{}^*$) zu einer Elektronentunnelungsrate ($\Gamma_e$) führt, die wenigstens drei Größenordnungen schneller ist als eine Lochtunnelungsrate ($\Gamma_h$), und wobei die Elektronentunnelungsrate ($\Gamma_e$) wenigstens zwei Größenordnungen schneller ist als die charakteristische Rate entsprechend der Präzession, die durch die Feinstrukturaufspaltung im Quantenpunkt ($\delta_{FS}/h$) bewirkt wird, wobei das Verfahren Folgendes beinhaltet:

   Anlegen einer ersten Sperrvorspannung an die Halbleiterregion (3); und
   Erzeugen eines Exzitons (22), das ein Elektron und ein Loch in dem Quantenpunkt (4) umfasst; und

Anlegen einer zweiten, unterschiedlichen niedrigen Sperrvorspannung an die Halbleiterregion (3) zu einem Zeitpunkt nach der Exzitonerzeugung, die im Vergleich zur charakteristischen Zeit entsprechend der Elektronentunnelungsrate ($\Gamma_e$) lang und im Vergleich zur charakteristischen Zeit entsprechend der Lochtunnelungsrate ($\Gamma_h$) kurz ist, um eine Speicherung des Loch-Spin in dem Quantenpunkt zuzulassen.

2. Verfahren nach Anspruch 1, wobei der gebundene Lochzustand (10) ein Grundlochzustand ist.

3. Verfahren nach Anspruch 1 oder 2, wobei der gebundene Elektronenzustand (11) ein Grundelektronenzustand ist.

4. Verfahren nach einem vorherigen Anspruch, wobei das Verhältnis ($\Delta E_{Ceff}$/ ($\Delta E_{Veff}$) zwischen der ersten und zweiten Energie wenigstens 1 beträgt.

5. Verfahren nach einem vorherigen Anspruch, wobei das Verhältnis maximal 1,5 oder maximal 1,3 beträgt.

6. Verfahren nach einem vorherigen Anspruch, wobei der Quantenpunkt (4) einen selbstassemblierten Quantenpunkt umfasst.

7. Verfahren nach einem der Ansprüche 1 bis 6, wobei die Halbleiterregion (3) intrinsisches Halbleitermaterial umfasst.

8. Verfahren nach einem der Ansprüche 1 bis 6, wobei die Halbleiterregion (3) eine erste Region aus Halbleitermaterial eines ersten Leitfähigkeitstyps und eine zweite Region aus Halbleitermaterial eines zweiten, entgegengesetzten Leitfähigkeitstyps umfasst und die Halbleiterregion (3) verarmt ist.

9. Verfahren nach einem vorherigen Anspruch, wobei der Quantenpunkt eine kleinste Dimension (H) von maximal 5 nm hat.

10. Verfahren nach einem vorherigen Anspruch, wobei das erste Halbleitermaterial Galliumarsenid ist.

11. Verfahren nach einem vorherigen Anspruch, wobei das zweite Halbleitermaterial Indiumarsenid umfasst.

12. Verfahren nach einem vorherigen Anspruch, wobei das Erzeugen des Exzitons (22) in dem Quantenpunkt (4) Folgendes beinhaltet:

Beleuchten des Quantenpunkts mit zirkular polarisiertem Licht.

13. Verfahren zur Quanteninformationsverarbeitung, das Folgendes beinhaltet:

Initialisieren von Loch-Spin nach einem vorherigen Anspruch, um einen Anfangszustand herzustellen;
Umwandeln des Anfangszustands in einen Endzustand; und
Lesen des Endzustands.

**Revendications**

1. Méthode d'initialisation d'un spin de trou dans un dispositif comprenant une région semi-conductrice (3) qui comprend un premier matériau semi-conducteur et une boîte quantique (4) qui comprend un deuxième matériau semi-conducteur intégré dans la région semi-conductrice (3), la boîte quantique (4) présentant un état de trou lié (10) situé à une première énergie ($\Delta E_{Veff}$) en dessous d'un bord de bande de valence de la région semi-conductrice et un état d'électron lié (11) situé à une deuxième énergie ($\Delta E_{Ceff}$) en dessous d'un bord de bande de conduction de la région semi-conductrice, dans laquelle un ratio ($\Delta E_{Ceff}$ / $\Delta E_{Veff}$) de la deuxième énergie sur la première n'est pas supérieur à 2,0,
dans laquelle la différence des masses effectives de l'électron ($m_e^*$) et du trou ($m_h^*$) donne une vitesse d'effet tunnel de l'électron ($\Gamma_e$) qui est plus rapide d'au moins trois ordres de grandeur qu'une vitesse d'effet tunnel du trou ($\Gamma_h$), et dans laquelle la vitesse d'effet tunnel de l'électron ($\Gamma_e$) est plus rapide d'au moins deux ordres de grandeur que la vitesse caractéristique correspondant à la précession provoquée par l'intervalle de structure fine dans la boîte quantique ($\delta_{FS}/h$),
la méthode comprenant les étapes consistant à :

appliquer une première polarisation inverse aux bornes de la région semi-conductrice (3) ; et
générer un exciton (22) comprenant un électron et un trou dans la boîte quantique (4) ; et
appliquer une deuxième polarisation inverse faible différente aux bornes de la région semi-conductrice (3), à un temps après la génération de l'exciton qui est long comparé au temps caractéristique correspondant à la vitesse d'effet tunnel de l'électron ($\Gamma_e$) et court comparé au temps caractéristique correspondant à la vitesse d'effet tunnel du trou ($\Gamma_h$), afin de permettre le stockage du spin de trou dans la boîte quantique.

2. Méthode selon la revendication 1, dans laquelle l'état de trou lié (10) est un état de trou de premier niveau.

3. Méthode selon la revendication 1 ou la revendication 2, dans laquelle l'état d'électron lié (11) est un état d'électron de premier niveau.

4. Méthode selon l'une quelconque des revendications précédentes, dans laquelle le ratio ($\Delta E_{Ceff}/\Delta E_{Veff}$) de la deuxième énergie sur la première est au moins égal à 1.

5. Méthode selon l'une quelconque des revendications précédentes, dans laquelle le ratio n'est pas supérieur à 1,5 ou n'est pas supérieur à 1,3.

6. Méthode selon l'une quelconque des revendications précédentes, dans laquelle la boîte quantique (4) comprend une boîte quantique auto-assemblée.

7. Méthode selon l'une quelconque des revendications 1 à 6, dans laquelle la région semi-conductrice (3) comprend un matériau semi-conducteur intrinsèque.

8. Méthode selon l'une quelconque des revendications 1 à 6, dans laquelle la région semi-conductrice (3) comprend une première région de matériau semi-conducteur ayant un premier type de conductivité et une deuxième région de matériau semi-conducteur ayant un deuxième type de conductivité opposé, et la région semi-conductrice (3) est appauvrie.

9. Méthode selon l'une quelconque des revendications précédentes, dans laquelle la boîte quantique possède une plus petite dimension (H) non supérieure à 5 nm.

10. Méthode selon l'une quelconque des revendications précédentes, dans laquelle le premier matériau semi-conducteur est de l'arséniure de gallium.

11. Méthode selon l'une quelconque des revendications précédentes, dans laquelle le deuxième matériau semi-conducteur comprend de l'arséniure d'indium.

12. Méthode selon l'une quelconque des revendications précédentes, dans laquelle la génération de l'exciton (22) dans la boîte quantique (4) comprend l'étape consistant à :

illuminer la boîte quantique avec de la lumière à polarisation circulaire.

13. Méthode de traitement d'informations quantiques, comprenant les étapes consistant à :

initialiser un spin de trou selon l'une quelconque des revendications précédentes afin de préparer un état initial ;
transformer l'état initial en un état final ; et
lire l'état final.

Fig. 1

Fig. 2

Fig. 3

Fig. 4a

Fig. 4b

S3

Fig. 4c

S4

Fig. 4d

S5

Fig. 4e

S1

Fig. 4f

Fig. 5

Fig. 6

Fig. 7

Fig. 8

Fig. 9

EP 2 760 050 B1

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **J. R. PETTA et al.** Coherent manipulation of coupled electron spins in semiconductor quantum dots. *Science,* 2005, vol. 309, 2180
- **B. D. GERARDOT et al.** Optical pumping of a single hole spin in a quantum dot. *Nature,* 2008, vol. 451, 441
- **M. ATATÜRE et al.** Quantum-dot spin-state preparation with near-unity fidelity. *Science,* 2006, vol. 312, 551
- **X. XU et al.** Fast spin state initialization in a singly charged InAs-GaAs quantum dot by optical cooling. *Physical Review Letters,* 2007, vol. 99, 097401
- **D. PRESS et al.** Complete quantum control of a single quantum dot spin using ultrafast optical pulses. *Nature,* 2008, vol. 456, 218
- **T. M. GODDEN et al.** Fast high fidelity hole spin initialization in a single InGaAs quantum dot. *Applied Physics Letters,* 2010, vol. 97, 061113
- **J. D. MAR et al.** Electrically tunable hole tunnelling from a single self-assembled quantum dot embedded in an n-i-Schottky photovoltaic cell. *Applied Physics Letters,* 2011, vol. 99, 031102
- **D. HEISS et al.** Observation of extremely slow hole spin relaxation in self-assembled quantum dots. *Physical Review B,* 2007, vol. 76, 241306
- **B. EBLE et al.** Hole spin initialization in Quantum Dots by a periodic train of short pulses. *Journal of Physics: Conference Series,* 2010, vol. 210, 012031